# EUROPEAN PATENT SPECIFICATION

(11) **EP 2 639 343 B1**
(45) Date of publication and mention of the grant of the patent: **14.01.2015**
(21) Application number: 13158849.3
(22) Date of filing: 12.03.2013
(51) Int. Cl.: C30B 21/02, C30B 11/00, C30B 29/22

(54) **A method of manufacturing thin layers of eutectic composites**
Verfahren zur Herstellung von Dünnschichten von eutektischen Verbundwerkstoffen
Procédé de fabrication de couches minces de composites eutectiques

(30) Priority: 16.03.2012 PL 39848112
(43) Date of publication of application: 18.09.2013
(73) Proprietor: Instytut Technologii Materialów Elektronicznych, 01-919 Warszawa (PL)
(72) Inventor: Klos, Andrzej, 00-019 Warszawa (PL); Lobodzinski, Wojciech, 04-325 Warszawa (PL); Pawlak, Dorota, 01-885 Warszawa (PL); Stefanski, Andrzej, 03-468 Warszawa (PL); Osewski, Pawe, 16-400 Suwalki (PL)
(74) Representative: Sielewiesiuk, Jakub

(56) References cited:
- US-A- 4 498 926
- ORERA V M ET AL: "Engineered self-organized microstructures using directional solidification of eutectics", PROCESSING AND PROPERTIES OF ADVANCED CERAMICS AND COMPOSITES III - MATERIALS SCIENCE AND TECHNOLOGY 2010 CONFERENCE AND EXHIBITION (MS AND T'10), HOUSTON, TX [US], vol. 225, 4 October 2011 (2011-10-04), pages 185-196, XP055064090, John Wiley & Sons [US] DOI: 10.1002/9781118144442.ch16 ISBN: 978-1-11-805998-2
- ESTER F J ET AL: "Processing and microstructural study of surface laser remelted Al2O3-YSZ-YAG eutectic plates", JOURNAL OF THE EUROPEAN CERAMIC SOCIETY, vol. 31, no. 7, June 2011 (2011-06), pages 1257-1268, XP028186949, Elsevier B.V. [NL] ISSN: 0955-2219, DOI: 10.1016/J.JEURCERAMSOC.2010.08.016 [retrieved on 2010-08-18]

## Description

The object of the invention is a method of manufacturing thin-film eutectic composites especially used in photonics, photoelectrochemistry and photovoltaics.

Manufacturing eutectic composites consists in heating the mixture having an eutectic composition to the melting point and then cooling at a rate that allows the occurrence of crystallization.

The mechanism of eutectic microstructures is exactly described only for metal eutectics - metal/metal. For the eutectics containing oxide compounds as one of the phases, the conditions ensuring growth of organized and directional structures are not known. In case of eutectics other than metal/metal it is very difficult to foresee the microstructure of a given eutectic, additionally, for many interesting material combinations the phase diagrams are not known, so the compositions of the mixture forming the eutectic and the melting point of the resulting material are not known. Publication F. R. Mollard and M. C. Flemings, Trans. AIME (1967), 10, 1534, and R. L. Ashbrook, J. Am. Cer. Soc. (1977), 60, 428, describes theoretical considerations, according to which for the growth of the self-organized eutectic structures the following growth conditions are necessary: simultaneous maintenance of flat crystal/melt boundary, large temperature gradient, low rate of growth and lack of convection.

However, in the case of the known methods of preparing composite eutectics simultaneous fulfilment of these conditions, in practice, is very difficult.

Works on obtaining oxide eutectic composites by the micro-pulling down method are known from such publications as J. L. Llorca and V. M. Orera, Progress in Mat. Sci. (2006),51,711; A. Yoshikawa et al., J. Cryst .Growth (2000),218,67; and K. Kolodziejak et al., Opto-Electr. Rev.(2006),14(3),205. However, this method does not allow to obtain the thin-film composites.

So far the only method of obtaining eutectic films of oxide materials, which is based on melting the material with a laser beam, is known from the publication A. Larrea et al., J. Eur. Ceram. Soc. (2002),22,191. However, this method does not allow obtaining the film of well-organized structure due to the moving of the melt zone parallel to the substrate. Crystal/melt boundary is not flat and therefore the crystallization of the eutectic micro/nanostructure, which is always perpendicular to the boundary, can not be arranged in a regular geometric pattern.

The process, in which the material tablets are formed, and then put on a piece of copper with a recess in the shape of a hemisphere and laser heated is known from the publication Zan-Hwey Chen, New-Jin Ho, Pouyan ShenMaterials Science and Engineering, A196 (1995), 253-260. Treatment details are not disclosed, but it can be assumed that the heating is a spot one, a semi-circular cavity is designed to concentrate the energy in the material. The authors of the article disclose that the sample during the process more or less assumes the shape of the recess. The method disclosed in this article does not ensure obtaining the most flat crystallization front at a relatively large area and has no significant advantages in comparison with the present invention.

In the present method, the point is to obtain the most flat crystallization front at a relatively large area. Therefore, the process according to the invention is carried out on flat plates. The heating is performed from two sides with halogen lamps with radiators with these characteristics, in order to obtain the most uniform distribution of the radiation power on the surface to be treated.

The method according to the invention allows obtaining directional eutectic metal-dielectric and dielectric-dielectric structures in the form of thin films having a homogeneous micro- or nano-structure using a mechanism of directional crystallization.

The method according to the invention is characteristic in that the material of eutectic composition is placed on a substantially flat backing plate in the device for directional crystallization and melts at the temperature at least equal to the eutectic temperature, and then in the volume of the molten material the temperature is lowered below the eutectic temperature, preferably up to the room temperature, the temperature gradient between the upper and lower surface of the material layer being perpendicular to the surface of the backing plate during the crystallization process.

Material of eutectic composition is placed on the backing plate, preferably in the form of a powder or previously compressed into tablets, preferably with a diameter of 5-8 mm and a thickness of 0.1 - 0.5 mm. The compression provides a high density of the input material and adequate shape of the samples.

The temperature in the volume of the eutectic layer of molten material is preferably decreased linearly or stepwise in time, in the direction from the lower to the upper surface of the layer so that the upper surface layer has a higher temperature than the lower one, due to which a temperature gradient is produced in the layer perpendicular from the substrate to the upper surface of the sample, giving a homogeneously organized micro- or nano-structure.

When the temperature is decreased linearly or stepwise in time, in the direction from the upper to the lower surface of the layer so that the lower surface layer has a higher temperature than the upper one, a temperature gradient is produced in the layer perpendicular from the upper surface to the substrate, meaning in the opposite direction, giving a homogeneous organized micro- or nano-structure.

Plate of the material having a melting point higher than the eutectic temperature of the crystallized material, preferably a refractory metal, is used as the backing plate. A backing plate may be preferably made of silicon, quartz, SiC or refractory ceramic material, most preferably of Al₂O₃ or ZrO₂ type with a thickness of not more than 0.5 mm.

A mixture of metal oxides of eutectic composition or a eutectic mixture of metal-metal oxide, or other eutectic mixtures are used as a material subjected to directional crystallization.

A backing plate with the input material is placed in the device for directional crystallization consisting preferably of high-temperature radiant heating system, material samples loading system, vacuum-tight chamber, vacuum pumping system, a system of process gas flow, control system of power supply, heaters' power and process gas flow.

A backing plate with a coated material is preferably introduced into a high-temperature radiant heating system in the area between the two coaxially arranged halogen radiators, upper and lower, heating the plate with the material from the top and from the bottom, into the focal spots of their elliptical reflectors, wherein a preferably tungsten filament is located in one of the focal spots of each reflector. Energy radiated by the filament is focused in an environment of the second ellipsoidal focal spot of the reflector at the surface of a diameter of about 10 mm. Energy radiated by both radiators concentrates in the same focal point in the reflectors' focal spots, where plate with a material layer is placed. The maximum temperature of the tungsten filament is about 2300⁰C. This allows achieving a temperature of up to about 2000⁰C on the surface of the sample with a diameter of about 10mm.

The temperature in the volume of the material layer on the plate is adjusted preferably by switching on, switching off or reducing the power of the lower and/or upper radiator.

After melting the material to produce a suitable temperature gradient in the material between the plate and upper or lower radiator, a moving screen made of a refractory material such as the acid-resistant steel, is preferably incorporated, thus the energy radiated by the filament growing cold is cut off. When the plate is being heated the screen extends beyond the heated area.

High-temperature radiant heating system and material samples loading system for reflector's focal spots is preferably placed in vacuum-tight chamber, allowing the programmed process gas injection to provide appropriate atmosphere during the process.

High purity nitrogen, or argon is preferably used as the process gas. In case of using materials which require it, the vacuum-tight chamber can be filled with the reducing atmosphere containing hydrogen or an oxidizing atmosphere.

Melting material is preferably carried out while heating with the upper and lower radiator. Radiant power is selected depending on the melting point of the material used, so that the entire volume of the material layer is molten, preferably so that the power of the lower and upper radiator is lower than the power of the upper or lower radiator, respectively by about 5-20%, depending on the molten material. This provides a lower temperature of lower or respectively upper surface of the sample and the backing plate, which is important for the further directional crystallization.

After melting the whole volume of the material layer the lower or upper radiator switches on, and the screen shutting off the heat is introduced between the plate and this radiator. The temperature gradient in the molten material is thus created, in the direction perpendicular to the backing plate and the crystallization process takes place extending from the lower to the upper surface of the layer or in the opposite direction. Then the second radiator turns off. Therefore, the cooling rate of the backing plate with a thickness of 0,2 mm in the initial phase reaches the value of about 1000°C/s. Supply system of both radiators allows independent gradual reduction of radiant power, which allows the modification of the process parameters. It is also possible to turn off both radiators at the same time.

The method according to the invention allows obtaining metal-dielectric and dielectric-dielectric directionally grown eutectic structures in the form of thin films having a homogeneous and directional micro-or nano-structure.

The method according to the invention may also be used to examine the mixtures interesting from the point of view of electromagnetic properties and applications in photonics, photochemistry, photovoltaics in order to obtain information whether they form an eutectic, studying the geometry of micro-or nano-structures of the studied eutectic.

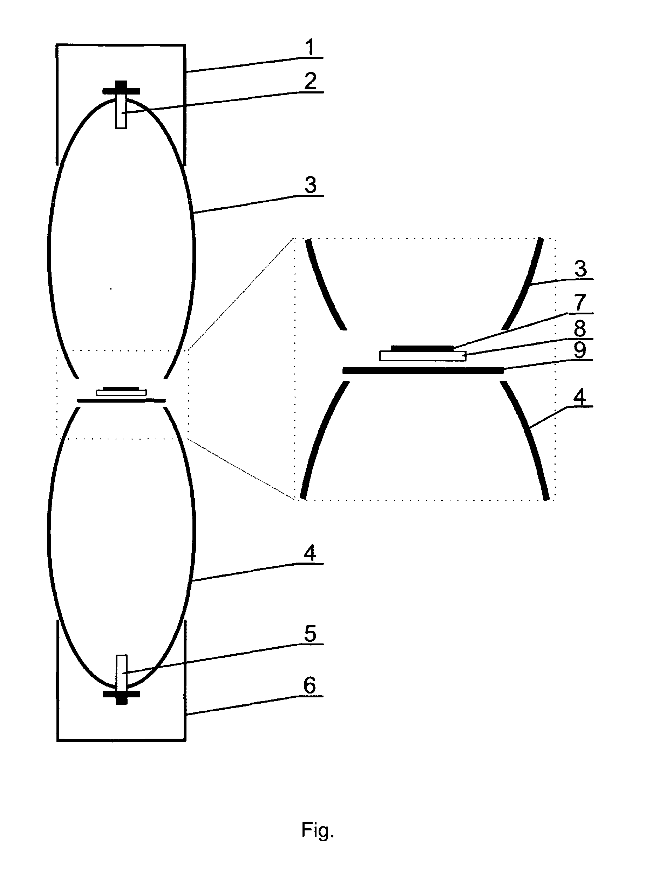

The examples mentioned below illustrate the method according to the invention in particular cases of its use, not limiting the scope of its application, based upon the drawing showing an example diagram of a high-temperature radiant heating system.

### Example 1

5g of a mixture of ZnO and WO₃ oxides with a molar ratio of 65:35 is mixed thoroughly in a mechanical mixer and then subjected to heat treatment at 300⁰C for 5 hours. A powder mixture of oxides with the ZnO-ZnWO₄ eutectic phases is obtained. It is poured into a metal mould with an inside diameter of 6 mm. After compression in a press a tablet with a diameter of 6mm and a thickness of 0.5 mm is obtained. Such prepared material 7 is placed on the flat backing plate 8 made of platinum with a diameter of 10 mm. The plate 8 with a compressed material 7 ZnO-ZnWO₄ eutectic is placed in the vacuum-tight chamber not shown in the drawing, between two ellipsoidal reflectors 3,4 the upper and lower radiators. In one of the focal spots of the upper reflector 3 and the lower reflector 4 two tungsten filaments 2 and 5 are located, sheltered from the outside with the shields 1 and 6 of the upper and lower radiator.

After closing the chamber and filling it with nitrogen, the plate 8 is introduced into the area of focal spots of reflectors 3 and 4, and the process of crystallization begins. The upper and lower radiator 1, 2, 3 and 4, 5, 6 turns on simultaneously in a quick warm-up mode so as to melt the eutectic mixture of ZnO-ZnWO₄. The power of the lower radiator is 10% lower than the power of the upper radiator. Eutectic point temperature amounts to 1187⁰C. After 30 sec. any radiator 4, 5, 6 turns off, and the screen 9, made of acid-resistant steel to reduce the maximum flow of heat from the bottom to the material crystallized, is simultaneously introduced between the backing plate 8 and the lower radiator 4, 5, 6. At this stage directional crystallization in the molten eutectic layer takes place. After 10 sec. the mode of reducing linearly the upper radiator 1, 2, 3 power to the value of 0% of the power within 30 sec turns on.

Thus, directionally crystallized eutectic layer of ZnO-ZnWO₄ is obtained. ZnO phase is separated in the form of submicron-sized lamellas directed upward perpendicular to the backing plate 8. It is a semiconductor material that after doping with magnetic ions can be diluted magnetic semiconductor (DMS).

### Example 2

5g of the mixture of SrO and TiO₂ with a molar ratio of 78 mol% TiO₂ and 22 mol% SrO is mixed thoroughly in a mechanical mixer and then poured into a metal mould with an inside diameter of 8 mm. After compression in a press a tablet with a diameter of 8 mm and a thickness of 0.5 mm is obtained. Such prepared material 7 is placed on a flat backing plate 8 made of platinum with a diameter of 10 mm made of Al₂O₃ ceramics. Next, the procedure is as in the Example 1. Eutectic point temperature amounts to 1440°C. 60 sec. after melting the eutectic mixture, any radiator 4, 5, 6 turns off, and the screen 9, made of acid-resistant steel to reduce the maximum flow of heat from the bottom to the material crystallized, is simultaneously introduced between the backing plate 8 and the lower radiator 4, 5, 6. Directional crystallization takes place in the molten eutectic layer. After 10 sec. the mode of reducing linearly the upper radiator 1, 2, 3 power to the value of 0% of the power within 40 sec. turns on.

A layer of SrTlO₃-TiO₂ eutectic is obtained directed perpendicular to the eutectic ceramic substrate with the thickness of 300µm. This system can be used as an anode for photovoltaic cells.

### Example 3

5g of the mixture of oxides Al₂O₃ and Pr₂O₃ with the purity of 99,995% with a molar ratio of 79,3% Al₂O₃ and 20,7% Pr₂O₃ is diluted in 5g of isopropanol. The solution is mixed thoroughly in a mechanical mixer and dried at the temperature of 100⁰C for 3 hours. The obtained powder mixture is poured into a metal mould with an inside diameter of 8 mm. After compression in a press a tablet with a diameter of 8mm and a thickness of 0.5 mm is obtained. Such prepared material 7 is placed on the flat backing plate 8 with a diameter of 10 mm made of ZrO₂. Next, the procedure is as in the Example 1, with a difference that the power of the lower radiator is lower than the power of the upper one by 8%. Eutectic point temperature amounts to 1800⁰C. 60 sec. after melting the input the lower radiator 4, 5, 6 turns off and the screen 9 of acid-resistant steel is simultaneously introduced between the backing plate 8 and the lower radiator 4, 5, 6. Directional crystallization takes place in the molten eutectic layer. After 5 sec. the mode of reducing linearly the upper radiator 1, 2, 3 power to the value of 0% of the power within 30 sec. turns on

The eutectic of PrAlO₃-PrAl₁₁O₁₈ is obtained in the form of PrAlO₃ fibres with several hundred nanometres in diameter submerged in a matrix of PrAl₁₁O₁₈. The fibres are oriented perpendicular to the backing plate 8. The thickness of eutectic composite layer amounts to 0.5 mm. Eutectic composition on ZrO₂ substrate is in the starting point for further technological processes, which results in a metal-dielectric structure, which might be used as a plasmonic sensor.

### Example 4

5g of the mixture of Bi₂O₃ and Ag with a molar ratio of 81.63 mol% Bi₂O₃ and 18,37 mol% Ag is triturated in an agate mortar. Then 5 ml of isopropanol is added in order to reduce the agglomeration of the mixture particles. After thorough mixing, the material together with the mortar is subjected to heat treatment for 2 hours at 100°C to evaporate isopropanol. Such obtained powder is placed on a flat backing plate 8 with a diameter of 10 mm made of platinum. Next, the procedure is as in the Example 1, with the difference that the power of the lower radiator equals the power of the upper radiator. Eutectic point temperature amounts to 687⁰C. 20 sec. after melting any radiator 4, 5, 6 turns off, and the screen 9, made of acid-resistant steel is simultaneously introduced between the backing plate 8 and the lower radiator 4, 5, 6. Directional crystallization takes place in the molten eutectic layer. After 10 sec. the upper radiator 1, 2, 3 turns off to the value of 0% of the power in a fast cooling mode.

Eutectic metal-dielectric composition of Bi₂O₃ - Ag is obtained, in which the silver phase is separated in the form of submicron-sized triangles. Resulting eutectic shows the effect of plasmon resonance in the visible range of the spectrum. This effect can be used in the construction of solar cells, sensors, lasers and other devices using plasmonic phenomenon.

## Claims

1. A method of manufacturing thin-film eutectic composites, **characterized in that** the material (7) of eutectic composition is placed on a substantially flat backing plate (8) in the device for directional crystallization and melts at the temperature at least equal to the eutectic temperature, and then in the volume of the melt material (7) the temperature is lowered below the eutectic temperature, preferably up to the room temperature, the temperature gradient between the upper and lower surface of the material (7) layer during the process of crystallization being perpendicular to the surface of the backing plate (8).

2. The method according to claim 1, **characterized in that** the material (7) previously compressed to the form of a tablet is placed on the baking plate (8) and the material (1) in the form of a powder is applied on the backing plate (8).

3. The method according to claim 1, **characterized in that** a mixture of metal oxides of eutectic composition or an eutectic mixture of metal-metal oxide or other eutectic mixtures are used as a material (7).

4. The method according to claim 1, **characterized in that** the plate of a refractory metal is used as a backing plate (8).

5. The method according to claim 1, **characterized in that** the plate made of silicon, quartz, SiC or refractory ceramic material, preferably of Al₂O₃ or ZrO₂ type with thickness of not more than 0.5 mm, is used as the backing plate (8).

6. The method according to claim 1, **characterized in that** the temperature in the volume of the eutectic layer of molten material (7) is decreased in the manner selected from the following:
a) linearly, in the direction from the lower to the upper surface of the layer so that the upper surface layer has a higher temperature than the lower one,
b) stepwise in time, in the direction from the lower to the upper surface of the layer so that the upper surface layer has a higher temperature than the lower one.
c) linearly, in the direction from the upper to the lower surface of the layer so that the lower surface layer has a higher temperature than the upper one,
d) stepwise in time, in the direction from the upper to the lower surface of the layer so that the lower surface layer has a higher temperature than the upper one,

7. The method according to claim 1, **characterized in that** the plate (8) with the material (7) is placed in the device for directional crystallization consisting preferably of high-temperature radiant heating system, material samples loading system (7), vacuum-tight chamber, vacuum pumping system, a gas flow system, power supply control system, heaters' power and process gas flow.

8. The method according to claim 1 or 7, **characterized in that** the backing plate (8) with the material (7) is introduced into a high-temperature radiant heating system in the area between the two coaxially arranged halogen radiators, upper and lower, heating the plate with the material from the top and from the bottom, into the focal spots of their elliptical reflectors (3, 4), wherein a preferably tungsten filament (2, 5) is located in one of the focal spots of each reflector (3, 4).

9. The method according to claim 1 or 8, **characterized in that** the temperature in the volume of the material layer (7) on the plate (8) is adjusted preferably by switching on, switching off or reducing the power of the lower and/or upper radiator.

10. The method according to claim 1 or 8, **characterized in that** after melting of the material (7) a moving screen (9) for example made of acid- resistant steel, shutting off the heat from the bottom to the top, is incorporated between the plate (8) and upper or lower radiator

11. The method according to claim 7, **characterized in that** the high-temperature heating system and the material (7) samples loading system for reflector's (3, 4) focal spots is placed in the vacuum-tight chamber.

12. The method according to claim 11, **characterized in that**, the vacuum-tight chamber is filled with process gas, preferably with high purity nitrogen or argon.

13. The method according to claim 11, **characterized in that**, the vacuum-tight chamber is filled with the reducing atmosphere containing hydrogen or an oxidizing atmosphere.

14. The method according to claim 8 or 9, **characterized in that** the material (7) melting is carried out while heating with the upper and lower radiator, wherein radiant power is selected depending on the melting point of the material.

15. The method according to claim 14, **characterized in that**, the radiant power is selected so that the power of the lower and upper radiator was lower than the power of the upper or lower radiator, respectively by about 5 -20%.

## Patentansprüche

1. Verfahren zur Herstellung von dünnschichtigen eutektischen Verbundwerkstoffen, **dadurch gekennzeichnet, dass** ein Material (7) mit einer eutektischen Zusammensetzung auf einer im Wesentlichen ebenen Grundplatte (8) in einer Vorrichtung zur gerichteten Kristallisation platziert und bei einer Temperatur, die der eutektischen Temperatur mindestens gleich ist, geschmolzen wird, und anschließend die Temperatur im Volumen des geschmolzenen Materials (7) unter die eutektische Temperatur, vorzugsweise bis zur Umgebungstemperatur, abgesenkt wird, wobei der Temperaturgradient zwischen der unteren und der oberen Oberfläche der Materialschicht (7) während des Kristallisationsprozesses senkrecht zur Oberfläche der Grundplatte (8) ist.

2. Verfahren nach Anspruch 1, **dadurch gekennzeichnet, dass** auf der Grundplatte (8) ein vorher zu einer Tablettenform zusammengepresstes Material (7) platziert wird oder das Material (7) auf die Grundplatte (8) in Pulverform aufgetragen wird.

3. Verfahren nach Anspruch 1, **dadurch gekennzeichnet, dass** als Material (7) ein Gemisch aus Metalloxiden mit einer eutektischen Zusammensetzung oder ein Metalloxid-Metall-Gemisch mit einer eutektischen Zusammensetzung, oder ein anderes eutektisches Gemisch verwendet wird.

4. Verfahren nach Anspruch 1, **dadurch gekennzeichnet, dass** als Grundplatte (8) eine Platte aus einem hochschmelzenden Metall verwendet wird.

5. Verfahren nach Anspruch 1, **dadurch gekennzeichnet, dass** als Grundplatte (8) eine Platte aus Silicium, aus Quarz , aus SiC oder aus einem hochschmelzenden keramischen Stoff, bevorzugt vom Typ Al₂O₃ oder ZrO₂, mit einer Dicke von nicht mehr als 0,5 mm verwendet wird.

6. Verfahren nach Anspruch 1, **dadurch gekennzeichnet, dass** die Temperatur im Volumen der eutektischen Schicht des geschmolzenen Materials (7) auf eine Weise abgesenkt wird, die aus den folgenden ausgewählt ist:
a) zeitlich linear, in einer Richtung von der unteren zur oberen Schichtoberfläche, so dass die obere Schichtoberfläche eine höhere Temperatur hat als die untere,
b) zeitlich sprunghaft, in einer Richtung von der unteren zur oberen Schichtoberfläche, so dass die obere Schichtoberfläche eine höhere Temperatur hat als die untere,
c) zeitlich linear, in einer Richtung von der oberen zur unteren Schichtoberfläche, so dass die untere Schichtoberfläche eine höhere Temperatur hat als die obere,
d) zeitlich sprunghaft, in einer Richtung von der oberen zur unteren Schichtoberfläche, so dass die untere Schichtoberfläche eine höhere Temperatur hat als die obere.

7. Verfahren nach Anspruch 1, **dadurch gekennzeichnet, dass** die Platte (8) mit dem Material (7) in einer Vorrichtung zur gerichteten Kristallisation platziert wird, die aus einem Hochtemperaturstrahler-Heizsystem, einem System zur Beschickung mit Materialproben (7), einer vakuumdichten Kammer, einem System der technologischen Gase sowie einem System zur Steuerung der Energieversorgung, der Strahlerleistung und des Durchflusses der technologischen Gase besteht.

8. Verfahren nach Anspruch 1 oder 7, **dadurch gekennzeichnet, dass** die Grundplatte (8) mit dem Material (7) in ein Hochtemperaturstrahler-Heizsystem in einen Bereich zwischen zwei koaxial angeordnete Halogenstrahler, einen oberen und einen unteren, in die Brennpunkte ihrer ellipsoiden Reflektoren (3,4) eingeführt wird, wobei sich in einem der Brennpunkte eines jeden Reflektors (3,4) ein Strahlungskörper (2,5), vorzugsweise aus Wolfram, befindet.

9. Verfahren nach Anspruch 1 oder 8, **dadurch gekennzeichnet, dass** die Temperatur im Volumen der Materialschicht (7) auf der Platte (8) durch Einschalten, Ausschalten oder Herabsetzung der Leistung des unteren und/oder oberen Strahlers geregelt wird.

10. Verfahren nach Anspruch 1 oder 8, **dadurch gekennzeichnet, dass** nach dem Schmelzen des Materials (7) zwischen die Platte (8) und den unteren oder den oberen Strahler eine bewegliche Abschirmung (9), zum Beispiel aus säurebeständigem Stahl, eingeführt wird, die die Hitzezufuhr von unten oder von oben unterbricht.

11. Verfahren nach Anspruch 7, **dadurch gekennzeichnet, dass** das Hochtemperatur-Heizsystem und das System zur Beschickung der Materialproben (7) in den Bereich der Brennpunkte der Reflektoren (3,4) in einer vakuumdichten Kammer angeordnet werden.

12. Verfahren nach Anspruch 11, **dadurch gekennzeichnet, dass** die vakuumdichte Kammer mit einem technologischen Gas, bevorzugt hochreinem Stickstoff oder Argon, gefüllt wird.

13. Verfahren nach Anspruch 11, **dadurch gekennzeichnet, dass** die vakuumdichte Kammer mit einer reduzierenden Atmosphäre, die Wasserstoff enthält, oder einer oxidierenden Atmosphäre, gefüllt wird.

14. Verfahren nach Anspruch 8 oder 9, **dadurch gekennzeichnet, dass** das Schmelzen des Materials (7) beim gleichzeitigen Heizen mit dem oberen und dem unteren Strahler durchgeführt wird, wobei die Leistung der Strahler in Abhängigkeit von der Schmelztemperatur des Materials gewählt wird.

15. Verfahren nach Anspruch 14, **dadurch gekennzeichnet, dass** die Leistung der Strahler so gewählt wird, dass die Leistung des unteren oder des oberen Strahlers um ca. 5-20% niedriger ist als die Leistung des entsprechend oberen oder unteren Strahlers.

## Revendications

1. Procédé de fabrication de composites eutectiques en couches minces, **caractérisé en ce que** la matière (7) de composition eutectique est placée sur une plaque de support sensiblement plane (8) dans in dispositif de cristallisation orientée et on fait fondre dans une température au moins égale à la température eutectique, puis dans un volume de matière (7) fondue on baisse la température au dessous de la température eutectique, de préférence jusque la température ambiante, le gradient de la température entre la surface inférieure et supérieure de la couche de la matière (7) durant le processus de cristallisation étant perpendiculaire à la surface de la plaque de support (8).

2. Procédé selon la revendication 1, **caractérisé en ce que** sur la plaque de support (8) on place la matière (7) comprimée auparavant sous forme de pastilles ou on applique la matière (7) sur la plaque de support (8) sous forme de poudre.

3. Procédé selon la revendication 1, **caractérise en ce que** comme matière (7) on met en oeuvre un mélange des oxydes de métaux de composition eutectique ou un mélange oxyde de métal-métal de composition eutectique, ou un autre mélange eutectique.

4. Procédé selon la revendication 1, **caractérisé en ce que** comme plaque de support (8) on met en oeuvre une plaque en métal hautement fusible.

5. Procédé selon la revendication 1, **caractérisé en ce que** comme plaque de support (8) on met en oeuvre une plaque en silicium, en quartz, en SiC ou en matière céramique hautement fusible, de préférence de type Al₂O₃ ou ZrO₂, d'épaisseur maximale de 0,5 mm.

6. Procédé selon la revendication 1, **caractérisé en ce que** la température du volume de la couche eutectique de la matière (7) fondue est baissée selon un procédé choisi parmi les suivants:
a) linéairement dans le temps, en direction depuis la surface inférieure vers la surface supérieure de la couche de sorte que la température de la surface supérieure de la couche est plus élevée que celle de la surface inférieure,
b) échelonné dans le temps, en direction depuis la surface inférieure vers la surface supérieure de la couche de sorte que la température de la surface supérieure de la couche est plus élevée que celle de la surface inférieure,
c) linéairement dans le temps, en direction depuis la surface supérieure vers la surface inférieure de la couche de sorte que la température de la surface inférieure de la couche est plus élevée que celle de la surface supérieure,
d) échelonné dans le temps, en direction depuis la surface supérieure vers la surface inférieure de la couche de sorte que la température de la surface inférieure de la couche est plus élevée que celle de la surface supérieure.

7. Procédé selon la revendication 1, **caractérisé en ce que** la plaque (8) avec la matière (7) est mise en place dans un dispositif de cristallisation orientée, constitué d'un système de chauffage à rayonnement de haute température, d'un système de chargement des échantillons de matière (7), d'une chambre étanche au vide, d'un système des gaz techniques ainsi que d'un système de commande de l'alimentation, de la puissance des radiateurs et du flux des gaz techniques.

8. Procédé selon la revendication 1 ou 7, **caractérisé en ce que** la plaque de support (8) avec la matière (7) est introduite dans le système de chauffage à rayonnement de haute température dans une zone entre deux radiateurs à halogène supérieur et inférieur, disposés de façon coaxiale, dans les foyers de leurs projeteurs elliptiques (3, 4), dans un des foyers de chaque projeteur (3, 4) étant placé un filament (2, 5), de préférence de tungstène.

9. Procédé selon la revendication 1 ou 8, **caractérise en ce que** la température dans le volume de la couche de matière (7) sur la plaque (8) est réglée en branchant, débranchant ou en limitant la puissance du radiateur inférieur et/ou supérieur.

10. Procédé selon la revendication 1 ou 8, **caractérisé en ce que** après avoir fondu la matière (7) on introduit entre la plaque (8) et le radiateur inférieur ou supérieur un écran mobile (9), par exemple en acier inoxydable, qui coupe l'arrivée de la chaleur depuis le bas vers le haut.

11. Procédé selon la revendication 7, **caractérisé en ce que** le système de chauffage à haute température et le système de chargement des échantillons de matière (7) dans la zone des foyers des projeteurs (3, 4) sont placés dans une chambre étanche au vide.

12. Procédé selon la revendication 11, **caractérisé en ce qu'**on remplit la chambre étanche au vide d'un gaz technique, de préférence avec de l'azote ou de l'argon de haute pureté.

13. Procédé selon la revendication 11, **caractérisé en ce qu'**on remplit la chambre étanche au vide d'une atmosphère réductrice comprenant de l'hydrogène ou une atmosphère oxydante.

14. Procédé selon la revendication 8 ou 9, **caractérisé en ce que** la fusion de la matière (7) est exécutée en chauffant simultanément avec le radiateur supérieur et inférieur, la puissance des radiateurs étant choisie selon la température de fusion de la matière.

15. Procédé selon la revendication 14, **caractérisé en ce que** la puissance des radiateurs est choisie de façon que la puissance du radiateur inférieur ou supérieur soit plus basse, respectivement, de la puissance du radiateur supérieur ou inférieur d'environ 5-20%.
